(19) Europäisches Patentamt
European Patent Office
Office européen des brevets

(11) **EP 4 519 708 B1**

(12) **EUROPÄISCHE PATENTSCHRIFT**

(45) Veröffentlichungstag und Bekanntmachung des Hinweises auf die Patenterteilung:
**08.04.2026   Patentblatt 2026/15**

(21) Anmeldenummer: **23722823.4**

(22) Anmeldetag: **05.05.2023**

(51) Internationale Patentklassifikation (IPC):
**G07D 7/04** *(2016.01)*          **G01R 33/345** *(2006.01)*
**G01R 33/381** *(2006.01)*        **G01N 24/10** *(2006.01)*
**G01R 33/60** *(2006.01)*         **G01R 33/44** *(2006.01)*

(52) Gemeinsame Patentklassifikation (CPC):
**G07D 7/04; G01N 24/10; G01R 33/381; G01R 33/445; G01R 33/60;** G01R 33/345

(86) Internationale Anmeldenummer:
**PCT/EP2023/025207**

(87) Internationale Veröffentlichungsnummer:
**WO 2023/213436 (09.11.2023 Gazette 2023/45)**

(54) **SENSORELEMENT, PRÜFVORRICHTUNG UND VERFAHREN FÜR DIE PRÜFUNG VON DATENTRÄGERN MIT SPINRESONANZ-MERKMAL**

SENSOR ELEMENT, TEST DEVICE, AND METHOD FOR TESTING DATA CARRIERS HAVING A SPIN RESONANCE FEATURE

ÉLÉMENT CAPTEUR, DISPOSITIF DE TEST ET PROCÉDÉ DE TEST DE SUPPORTS DE DONNÉES AYANT UNE CARACTÉRISTIQUE DE RÉSONANCE DE SPIN

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität:  **06.05.2022   DE 102022001594**

(43) Veröffentlichungstag der Anmeldung:
**12.03.2025   Patentblatt 2025/11**

(73) Patentinhaber: **Giesecke+Devrient Currency Technology GmbH**
**81677 München (DE)**

(72) Erfinder:
• **HUBER, Stephan**
  **80634 München (DE)**
• **SCHOLZ-RIECKE, Sina**
  **81247 München (DE)**

(74) Vertreter: **Giesecke+Devrient IP**
**Prinzregentenstraße 161**
**81677 München (DE)**

(56) Entgegenhaltungen:
EP-A2- 1 646 057     DE-A1- 3 408 086
US-A- 3 638 104      US-A- 5 149 946
US-A- 5 302 898      US-A1- 2004 251 904

**Beschreibung**

Die Erfindung betrifft ein Sensorelement für die Echtheitsprüfung eines flächigen Datenträgers, insbesondere einer Banknote, mit einem Spinresonanz-Merkmal. Die Erfindung betrifft auch eine Prüfvorrichtung mit einem solchen Sensorelement und ein Verfahren zur Echtheitsprüfung mit einem solchen Sensorelement oder einer solchen Prüfvorrichtung.

Datenträger, wie Wert- oder Ausweisdokumente, aber auch andere Wertgegenstände, wie etwa Markenartikel, werden zur Absicherung oft mit Sicherheitselementen versehen, die eine Überprüfung der Echtheit der Datenträger gestatten und die zugleich als Schutz vor unerlaubter Reproduktion dienen. Es ist bekannt, bei der maschinellen Echtheitsprüfung Sicherheitselemente mit Spinresonanz-Merkmalen zur Absicherung von Dokumenten und anderen Datenträgern einzusetzen. Die Sicherheitselemente sind dazu mit Substanzen versehen, die eine Spinresonanz-Signatur aufweisen. Zu den für die Echtheitsprüfung einsetzbaren Spinresonanz-Signaturen gehören insbesondere Kernspin-Resonanz-Effekte (Nuclear Magnetic Resonance, NMR), Elektronspin-Resonanz-Effekte (ESR) und ferromagnetische Resonanz-Effekte (FMR).

Bei der Prüfung von Banknoten werden zur Detektion der Spinresonanz-Signaturen meist drei verschiedene Magnetfelder im Messbereich beispielsweise einer Banknotenbearbeitungsmaschine erzeugt. Dabei handelt es sich konkret um ein quasistatisches Polarisationsfeld $B_0$, das parallel zur Axialrichtung (z-Richtung) des Luftspalts eines magnetischen Kreises verläuft. Ein zweites Magnetfeld ist durch ein Modulationsfeld $B_{mod}$ gebildet, welches ebenfalls parallel zur z-Achse verläuft und typischerweise eine Frequenz $f_{mod}$ im kHz-Bereich hat. Zur Anregung von Übergängen zwischen den aufgespaltenen Spin-Energieniveaus der Spinresonanz-Signatur-Substanzen ist ein Anregefeld $B_1$ vorgesehen, das senkrecht zur $B_0$-Richtung polarisiert ist. Das Anregefeld schwingt dabei mit der Resonanzfrequenz des Materials, die auch als Larmorfrequenz bezeichnet wird, und die proportional zum Polarisationsfeld $B_0$ ist.

Zur Erzeugung des Polarisationsfeldes $B_0$ kommt häufig ein magnetischer Kreis zum Einsatz, der den magnetischen Fluss von Permanentmagneten und/oder Spulen zu einem Luftspalt leitet, in dem die Prüfung der flächigen Datenträger stattfindet.

Für die Erzeugung des Anregefelds $B_1$ wird ein Hochfrequenz-Resonator, beispielsweise ein Streifenleitungs-Resonator, verwendet. Mit Hilfe einer Detektor-Diode wird die vom Resonator reflektierte RF-Leistung gemessen. Ist ein Prüfling bei der eingekoppelten Frequenz in Resonanz, so ändert sich die Resonatorgüte und damit die vom Resonator reflektierte Leistung. Aufgrund der Feldmodulation $B_{mod}$ oszilliert der genaue Wert der Larmor-Frequenz des Prüflings, und das Messsignal ist mit $f_{mod}$ amplitudenmoduliert. Die spektrale Leistungsverteilung am Eingang der Detektordiode zeigt dann neben der zentralen Mikrowellen-Trägerfrequenz um $\pm$ $f_{mod}$ versetzte Modulationspeaks, die die gewünschte Spinresonanz-Information tragen.

Bei der Echtheitsprüfung eines Datenträgers besteht oft das Bedürfnis, mehrere unabhängige Resonatoren mit gleicher Frequenz betreiben zu können, beispielsweise um die Spinresonanz-Information ortsaufgelöst erfassen zu können. Hierbei benötigt man herkömmlicherweise für jeden Resonator einen unabhängigen Mikrowellenkreis für die Detektion und Auswertung des Messsignals. Diese Mikrowellenkreise werden typischerweise mittels SMD-Komponenten und Streifenleitungen auf Platinen realisiert. Bei mehreren unabhängigen Kreisen wird hier sehr viel Bauraum benötigt. Steht dieser Bauraum nicht zur Verfügung, kann es schnell zu einem Übersprechen der verschiedenen Kreise und damit zu einer Signalverfälschung kommen.

Darüber hinaus ist die Funktionalität vieler Elemente in einem Mikrowellen-Schaltkreis durch die Geometrie der beteiligten Elemente definiert. Insbesondere bei hohen Frequenzen, also kleinen Wellenlängen, hat die Fertigungstoleranz eine starke Auswirkung auf die Funktionalität des Kreises. Sollen beispielsweise mehrere identische Mikrowellen-Kreise parallel aufgebaut werden, etwa für die oben genannte ortsaufgelöste Messung von Spinresonanzen, so können sich die nominell identischen MikrowellenKreise in der Praxis in ihrer Funktionalität beträchtlich unterscheiden und eine zuverlässige ortsaufgelöste Messung erschweren.

US 3 638 104 A offenbart eine Vorrichtung zur Messung von NMR Eigenschaften von Objekten und die US 5 149 946 A zeigt eine Vorrichtung zum Prüfen von Spinresonanzmerkmalen auf flächigen Datenträgern.

Ausgehend davon liegt der Erfindung die Aufgabe zugrunde, die Nachteile des Stands der Technik zu vermeiden und insbesondere ein Sensorelement der eingangs genannten Art bereit zu stellen, das eine verbesserte Erfassung des Spinresonanz-Merkmals eines flächigen Datenträgers erlaubt.

Diese Aufgabe wird durch die Merkmale der unabhängigen Ansprüche gelöst. Weiterbildungen der Erfindung sind Gegenstand der abhängigen Ansprüche.

Die Erfindung stellt ein Sensorelement für die Prüfung, insbesondere Echtheitsprüfung, eines flächigen Datenträgers mit einem Spinresonanz-Merkmal bereit. Bei dem flächigen Datenträger kann es sich beispielsweise um eine Banknote handeln. Das Sensorelement enthält einen Magnetkern mit einem Luftspalt, in den der flächige Datenträger zur Prüfung einbringbar ist, eine Polarisationseinrichtung zu Erzeugung eines statischen magnetischen Flusses in dem Luftspalt, sowie eine Resonatoreinrichtung zur Anregung des Spinresonanz-Merkmals des zu prüfenden Datenträgers in dem Luftspalt, mit zumindest einem von einer Signalquelle gespeisten Streifenleitungs-Resonator. Bei dem Spinresonanz-Merkmal handelt es sich bevorzugt um ein ESR-Merkmal.

Das Sensorelement enthält weiter eine Modulationseinrichtung zur Erzeugung eines zeitlich variierenden magnetischen Modulationsfelds in dem Luftspalt parallel zu dem statischen Magnetfeld. Die Modulationseinrichtung umfasst eine Mehrzahl von Modulationsspulen, die für die Erzeugung verschiedener Modulationsfrequenzen ausgebildet und eingerichtet sind, so dass das durch die Modulationseinrichtung zusammen mit der Polarisationseinrichtung erzeugte modulierte Magnetfeld an verschiedenen Orten innerhalb des Luftspalts verschiedene Modulationsfrequenzen aufweist.

Grundsätzlich zeichnen sich Streifenleitungs-Resonatoren insbesondere dadurch aus, dass ihr sensitiver Bereich sehr gut zugänglich ist und sie für flächige Proben, wie sie die zu prüfenden Banknoten darstellen, einen sehr hohen Füllfaktor aufweisen. Die Streifenleitungs-Resonatoren werden nachfolgend teilweise auch nur kurz als Resonatoren bezeichnet.

Die Resonatoreinrichtung ist insbesondere auch zur Erfassung von Spinresonanz-Signalen des Spinresonanz-Merkmals ausgebildet. Die Resonatoreinrichtung kann insbesondere ein Antwortsignal des Spinresonanz-Merkmals aufnehmen und an einen Detektor ausgeben. Die Spinresonanzen können beispielsweise mit einem Dauerstrich (CW)-Verfahren, einem gepulsten Verfahren oder einem Rapid-Scan-Verfahren bestimmt werden.

In einer vorteilhaften Ausgestaltung ist vorgesehen, dass die Modulationsspulen der Modulationseinrichtung versetzt nebeneinander angeordnet sind. Jede Modulationsspule erzeugt dann einen räumlichen Bereich des Modulationsfelds mit ihrer jeweiligen Modulationsfrequenz.

Mit Vorteil ist zumindest eine oder sind vorzugsweise sogar alle Modulationsspulen der Modulationseinrichtung durch Planarspulen gebildet, die in einer Ebene eine oder mehrere Windungen um eine Axialrichtung des Luftspalts aufweisen. Die genannte Ebene mit der einen oder den mehreren Windungen steht vorteilhaft senkrecht auf der Axialrichtung (z-Richtung) des Luftspalts, also der Richtung zwischen den an den Luftspalt angrenzenden Polflächen des Magnetkerns. Dadurch wird das Modulationsfeld vorteilhafterweise parallel zum Polarisationsfeld ausgerichtet.

Die Modulationsspulen sind vorteilhaft alle in derselben Ebene auf einem gemeinsamen Spulenträger, insbesondere einer gemeinsamen Leiterplatte, angeordnet.

Bei einer vorteilhaften Ausgestaltung der Erfindung sind die Modulationsspulen zur Erzeugung von Modulationsfrequenzen ausgebildet und eingerichtet, die nicht in einem einfachen ganzzahligen Verhältnis zueinander stehen, insbesondere nicht in einem Verhältnis 1:n, mit einer natürlichen Zahl n kleiner als 6. Mit anderen Worten stehen die erzeugten Modulationsfrequenzen je zweier Modulationsspulen dann nicht in einem einfachen Verhältnis 1:2, 1:3, 1:4, 1:5, oder einem dazu reziproken Verhältnis.

Die Modulationsspulen sind bevorzugt zur Erzeugung von Modulationsfrequenzen ausgebildet und eingerichtet, die sich um mehr als ihre Linienbreite und um mehr als die Linienbreite des Hochfrequenz-Signals der Resonatoren unterscheiden. Beispielsweise unterscheiden sich die Modulationsfrequenzen der Mehrzahl von Modulationsspulen jeweils um mehr als 5%, bevorzugt um mehr als 20%.

Bei einer vorteilhaften Ausgestaltung sind die Modulationsspulen der Modulationseinrichtung in Form eines eindimensionalen, insbesondere linearen, Arrays angeordnet. Das eindimensionale Array erstreckt sich insbesondere quer zu einer Transportrichtung des zu prüfenden Datenträgers und ermöglicht einen zweidimensionalen Scan eines in Transportrichtung bewegten Datenträgers.

Auch eine Anordnung mehrerer Modulationsspulen in Transportrichtung hintereinander ist möglich, insbesondere in Kombination mit einem räumlich inhomogenen Polarisationsfeld, und kann zur Erzeugung einer Spektralauflösung genutzt werden. Bei einer weiteren vorteilhaften Ausgestaltung sind die Modulationsspulen der Modulationseinrichtung in Form eines zweidimensionalen Arrays angeordnet, beispielsweise auf den Gitterpunkten eines regelmäßigen Gitters, beispielsweise in rechteckiger, hexagonaler oder zeilenweise versetzter Anordnung, und ermöglichen eine zweidimensionale Ortsauflösung auch an einem ruhenden Datenträger.

Die Anordnung der Modulationsspulen erstreckt sich mit Vorteil über die gesamte Breite des zu prüfenden Datenträgers, insbesondere einer Banknote, um eine Prüfung auf Vollständigkeit zu ermöglichen.

Gemäß einer vorteilhaften Ausgestaltung weist die Resonatoreinrichtung eine Mehrzahl von Streifenleitungs-Resonatoren auf, insbesondere ist bevorzugt vorgesehen, dass die Anzahl der Streifenleitungs-Resonatoren in der Resonatoreinrichtung gleich der Anzahl der Modulationsspulen in der Modulationseinrichtung ist, oder dass die Anzahl der Streifenleitungs-Resonatoren in der Resonatoreinrichtung ein ganzzahliges Vielfaches der Anzahl der Modulationsspulen in der Modulationseinrichtung ist.

Die Streifenleitungs-Resonatoren der Resonatoreinrichtung haben vorteilhaft die gleiche Resonanzfrequenz, beispielsweise mit einer Frequenzabweichung von weniger als 1%, bevorzugt von weniger als 0,1 %. Vorzugsweise sind die Streifenleitungs-Resonatoren der Resonatoreinrichtung sogar auf Betrieb in der gleichen räumlichen Mode ausgelegt und eingerichtet. Weiter ist alternativ oder zusätzlich mit Vorteil vorgesehen, dass die Streifenleitungs-Resonatoren der Resonatoreinrichtung die gleiche geometrische Form, beispielsweise eine quadratische, eine rechteckige oder eine Ring-Form aufweisen. Bevorzugt sind die Streifenleitungs-Resonatoren auf den Betrieb bei derselben Anregefrequenz ausgelegt und eingerichtet, beispielsweise mit einer Frequenzabweichung von weniger als 1%, bevorzugt von weniger als 0,1 %.

Die Streifenleitungs-Resonatoren der Resonatoreinrichtung sind bevorzugt in derselben Ebene, vorteilhaft auf einem gemeinsamen Resonatorträger, insbesondere einer gemeinsamen Leiterplatte, angeordnet. Die genannte Ebene steht zweckmäßig senkrecht auf der Richtung des statischen magnetischen Flusses. Da die flächigen Streifenleitungs-Resonatoren ein $B_1$-Feld mit Feldkomponenten vorrangig in der Ebene der Resonatoren erzeugen, steht das erzeugte Feld dann senkrecht auf dem Polarisationsfeld $B_0$, wie für die Spinresonanzanregung benötigt.

In einer vorteilhaften Erfindungsvariante erzeugt die Polarisationseinrichtung am Ort der Streifenleitungs-Resonatoren jeweils im Wesentlichen den gleichen statischen magnetischen Fluss. Die maximale Abweichung des statischen magnetischen Flusses am Ort verschiedener Streifenleitungs-Resonatoren beträgt dabei mit Vorteil weniger als 2%.

Bei einer anderen, ebenfalls vorteilhaften Erfindungsvariante erzeugt die Polarisationseinrichtung im Luftspalt einen räumlich inhomogenen statischen magnetischen Fluss, beispielsweise um eine Spektralauflösung bei der Messung zu erreichen.

In vorteilhaften Ausgestaltungen befinden sich jeweils mehrere, insbesondere jeweils gleich viele, Streifenleitungs-Resonatoren im Bereich des Modulationsfeldes jeder Modulationsspule. Im Falle von gleichartigen, gemeinsam beschalteten Streifenleitungs-Resonatoren ermöglicht dies eine Verbesserung des Signal-zu-Rausch-Verhältnisses. Insbesondere kann jeder Modulationsspule ein NxM-Array von Streifenleitungs-Resonatoren zugeordnet sein, wobei N und M natürliche Zahlen sind und zumindest einer der Werte von N und M größer als 1 ist, wobei die Streifenleitungs-Resonatoren des NxM-Arrays jeweils alle von derselben Signalquelle gespeist sind und elektrisch parallel und/ oder in Reihe geschaltet sind.

In einer weiteren vorteilhaften Ausgestaltung befinden sich jeweils mehrere, insbesondere jeweils gleich viele Streifenleitungs-Resonatoren mit verschiedener Resonanzfrequenz im Bereich des Modulationsfeldes jeder Modulationsspule. Insbesondere werden die Streifenleitungs-Resonatoren mit verschiedenen, jeweils zur Resonanzfrequenz passenden Anregefrequenzen angeregt. So lässt sich zusätzlich zur Ortsauflösung eine Spektralauflösung erzielen.

Bei einer anderen ebenfalls vorteilhaften Ausgestaltung enthält das Sensorelement nur einen einzelnen bzw. wenige Streifenleitungs-Resonatoren mit ausgedehnter Feldverteilung, die jeweils den Bereich mehrerer Modulationsspulen überdecken. Die ausgedehnte Feldverteilung enthält vorteilhaft mehrere lokalisierte Feldmaxima, beispielsweise durch den Betrieb der Einzelresonatoren in einer höheren räumlichen Mode.

In vorteilhaften Ausgestaltungen ist vorgesehen, dass das modulierte Magnetfeld im Messbereich jedes Streifenleitungs-Resonators $i_\mu$ im Wesentlichen nur eine einzige Modulationsfrequenz $f_{Mod,i}$ aufweist.

Dieselbe Modulationsfrequenz $f_{Mod,i}$ kann jedoch im Messbereich mehrerer Streifenleitungs-Resonatoren $i_1, ..., i_\mu, ..., i_n$ mit n ≥ 1 vorliegen. Daneben sind weitere Streifenleitungs-Resonatoren $j_1, ..., j_n$ vorgesehen, in deren Messbereich das modulierte Magnetfeld eine andere Modulationsfrequenz $f_{Mod,j}$ aufweist. Das Übersprechen dieses Modulationsfelds $B_{Mod,j}$ auf den betrachteten, beispielsweise benachbarten, Streifenleitungsresonator $i_\mu$ wird durch einen Kontaminationsfaktor

$$\chi_{i_\mu j} = \frac{\int B_{Mod,j} dV_{i_\mu}}{\int B_{Mod,i} dV_{i_\mu}}$$

beschrieben, wobei sich die Integrale über das Volumen $V_{i_\mu}$ erstrecken, das den sensitiven Bereich des Resonators $i_\mu$ erfasst. Die Summe $S_{i_\mu}$ der Kontaminationsfaktoren am Ort des Resonators $i_\mu$ beschreibt dann den Beitrag aller Modulationsfeldkomponenten anderer Frequenzen:

$$S_{i_\mu} = \sum_{j \neq i} \chi_{i_\mu j}$$

Diese Summe $S_{i_\mu}$ ist mit Vorteil für alle Streifenleitungs-Resonatoren $i_\mu$ jeweils kleiner als 2%, insbesondere kleiner als 0,5 %. Dies ermöglicht eine sauberere Trennung der Resonatoren anhand ihrer jeweils zugeordneten Modulationsfrequenzen.

Der Luftspalt weist vorteilhaft eine Höhe, also eine Abmessung in z-Richtung, von weniger als 10 mm, vorzugsweise von weniger als 5 mm auf.

Dadurch lässt sich ein besonders starkes Polarisationsfeld, also ein starker statischer magnetischer Fluss, im Luftspalt erzeugen.

Die Erfindung enthält auch eine Prüfvorrichtung für die Prüfung eines flächigen Datenträgers, insbesondere einer Banknote, mit einem Spinresonanz-Merkmal mit einem Sensorelement der oben beschriebenen Art und genau einer Signalquelle, von der alle Streifenleitungs-Resonatoren der Resonatoreinrichtung gespeist werden.

Vorteilhaft enthält die Prüfvorrichtung weiter eine Transporteinrichtung, die die zu prüfenden flächigen Datenträger entlang eines Transportpfades in den Luftspalt des Magnetkerns einbringt bzw. durch den Luftspalt des Magnetkerns hindurchführt, wobei die Modulationsspulen der Modulationseinrichtung in Form eines eindimensionalen Arrays angeordnet sind, das sich quer zur Richtung des Transportpfades erstreckt. , Vorzugsweise ist die Transporteinrichtung auf einen schnell laufenden Transport, beispielsweise zwischen 1 m/s und 12 m/s, der flächigen Datenträger eingerichtet.

Die Erfindung enthält auch ein Verfahren zur Prüfung eines flächigen Datenträgers, insbesondere einer Banknote, mit einem Spinresonanz-Merkmal mittels eines Sensorelements der beschriebenen Art oder einer Prüfvorrichtung der beschriebenen Art, wobei bei dem Verfahren

- ein zu prüfender flächiger Datenträger in den Luftspalt des Magnetkerns des genannten Sensorelements eingebracht wird,

- mit der Polarisationseinrichtung ein statischer magnetischer Fluss und mit der Modulationseinrichtung ein zeitlich variierendes magnetisches Modulationsfeld in dem Luftspalt erzeugt wird, so dass das durch die Modulationseinrichtung zusammen mit der Polarisationseinrichtung erzeugte modulierte Magnetfeld an verschiedenen Orten innerhalb des Luftspalts verschiedene Modulationsfrequenzen aufweist, und

- mit der Resonatoreinrichtung das Spinresonanz-Merkmal des zu prüfenden Datenträgers angeregt wird.

Vorteilhaft wird mit der Resonatoreinrichtung auch ein durch die Anregung erzeugtes Antwortsignal des Spinresonanz-Merkmals aufgenommen und an einen Detektor ausgegeben. Die Anregung des Spinresonanz-Merkmals und/oder die Aufnahme des Antwortsignals des Spinresonanz-Merkmals kann in einem Dauerstrich (CW)-Verfahren, in einem gepulsten Verfahren oder in einem Rapid-Scan-Verfahren erfolgen.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:

Fig. 1 schematisch eine Prüfvorrichtung eines Banknotenbearbeitungssystems für die Messung von Spin-Resonanzen eines Banknotenprüflings,

Fig. 2 schematisch die Ausbildung der Resonatoreinrichtung und der Modulationseinrichtung eines erfindungsgemäßen Sensorelements in einem ersten Ausführungsbeispiel,

Fig. 3 die spektrale Leistungsverteilung des von dem Sensorelement nach Fig. 2 reflektierten RF-Signals für unterschiedliche Modulationsfrequenzen, und

Fig. 4 schematisch die bei der beschriebenen Simulation verwendete Beschaltung eines Sensorelements mit einem Array aus zwei Modulationsspulen und zwei quadratischen $\lambda/2$-Streifenleitungs-Resonatoren.

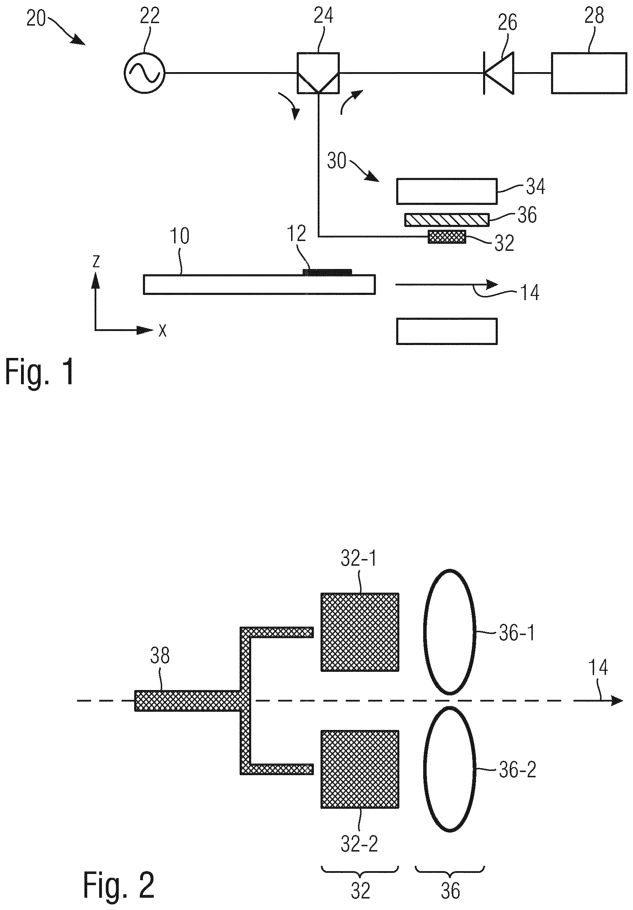

Die Erfindung wird nun am Beispiel der Echtheitsprüfung von Banknoten erläutert. Figur 1 zeigt dazu schematisch eine Prüfvorrichtung 20 eines Banknotenbearbeitungssystems für die Messung von Spin-Resonanzen eines Banknotenprüflings 10.

Der Banknotenprüfling 10 weist ein zu prüfendes Spinresonanz-Merkmal 12 auf, dessen charakteristische Eigenschaften zum Nachweis der Echtheit der Banknote dienen. Für die Echtheitsprüfung wird der Banknotenprüfling 10 entlang eines Transportpfads 14 durch ein erfindungsgemäßes Sensorelement 30 der Prüfvorrichtung 20 geführt. Zur Detektion von Spinresonanz-Signaturen des Spinresonanz-Merkmals 12 erzeugt das Sensorelement 30 im Messbereich drei verschiedene Magnetfelder.

Zum einen wird durch eine Polarisationseinrichtung 34 ein statischer magnetischer Fluss parallel zur z-Achse im Messbereich erzeugt. Zum zweiten erzeugt eine Modulationseinrichtung 36 ein zeitlich variierendes magnetisches Modulationsfeld in dem Luftspalt, das ebenfalls parallel zur z-Achse verläuft und Modulationsfrequenzen $f_{Mod}$ im Bereich zwischen 1 kHz bis 1 MHz aufweist. Während herkömmliche Modulationseinrichtungen in der Regel nur eine einzige Modulationsfrequenz erzeugen, enthält die erfindungsgemäße Modulationseinrichtung 36 in der weiter unten genauer beschriebenen Weise mehrere Modulationsspulen, die zur Erzeugung verschiedener Modulationsfrequenzen ausgebildet und eingerichtet sind.

Schließlich erzeugt eine Resonatoreinrichtung 32 ein Anregefeld, das die Energieübergänge zwischen den Spin-Energieniveaus im Spinresonanz-Merkmal 12 induziert. Das Anregefeld hat typischerweise Frequenzen oberhalb von 1 GHz und ist senkrecht zur z-Richtung polarisiert.

Die Frequenz des Anregefelds ist dabei auf die Larmor-Frequenz des nachzuweisenden Spinresonanz-Merkmals 12 abgestimmt, um dessen Spinresonanz-Signatur messen und für die Echtheitsprüfung verwenden zu können. Die Prüfvorrichtung 20 enthält hierzu eine Signalquelle 22, deren Anregefrequenz $f_{MW}$ der erwarteten Larmor-Frequenz des Spinresonanz-Merkmals 12 entspricht. Das Anregesignal der Signalquelle 22 wird über einen Duplexer 24 der Resonatoreinrichtung 32 zugeführt und erzeugt dort ein magnetisches Wechselfeld der Frequenz $f_{MW}$.

Bei der vorliegenden Erfindung umfasst die Resonatoreinrichtung 32 zur Erzeugung des Anregefelds in der weiter unten genauer beschriebenen Weise einen oder mehrere Streifenleitungs-Resonatoren. Bei einem Streifenleitungs-Resonator handelt es sich um eine leitende Struktur mit einer charakteristischen Länge 1, die auf einem Träger, wie etwa einer Leiterplatte oder einer Keramik, aufgebracht ist. Passt die Wellenlänge $\lambda$ des eingekoppelten Hochfrequenz-Signals auf der Leiterplatte zur Dimensionierung der Leiterstruktur, so kann sich eine stehende Welle ausbilden, der Resonator ist dann bei der zu $\lambda$ gehörigen Frequenz in Resonanz.

Streifenleitungs-Resonatoren zeichnen sich insbesondere dadurch aus, dass ihr sensitiver Bereich sehr gut zugänglich ist und sie für flächige Proben, wie sie die zu prüfenden Banknoten darstellen, einen sehr hohen Füllfaktor aufweisen.

Neben den genannten Elementen enthält die Prüfvorrichtung 20 eine Detektor-Diode 26 zur Messung der von der Resonatoreinrichtung 32 reflektierten Hochfrequenz-Leistung und eine Auswerteeinheit 28 zur Auswertung und gegebenenfalls Anzeige des Messergebnisses. Ist das Spinresonanz-Merkmal 12 bei einer eingekoppelten Frequenz $f_{MW}$ in Resonanz, so ändert sich die Resonatorgüte und damit die von den Streifenleitungs-Resonatoren reflektierte Leistung. Aufgrund der Modulation des statischen Polarisationsfelds durch die Modulationseinrichtung 36 oszilliert der genaue Wert der Larmor-Frequenz der Probe, so dass das erhaltene Messsignal mit den Modulationsfrequenzen amplitudenmoduliert ist.

Figur 2 zeigt schematisch die Ausbildung der Resonatoreinrichtung 32 und der Modulationseinrichtung 36 bei einem erfindungsgemäßen Sensorelement 30 nach einem ersten Ausführungsbeispiel der Erfindung. Das Sensorelement 30 enthält in diesem Ausführungsbeispiel eine Resonatoreinrichtung 32 aus einem Array von gemeinsam beschalteten Streifenleitungs-Resonatoren 32-1, 32-2 in Kombination mit einer Modulationseinrichtung 36 aus einem Array aus Modulationsspulen 36-1, 36-2.

In der Figur ist zur Illustration des Grundprinzips eine Ausgestaltung mit lediglich zwei Resonatoren 32-1, 32-2 und lediglich zwei Modulationsspulen 36-1, 36-2 gezeigt, es versteht sich jedoch, dass auch eine größere Anzahl von Resonatoren 32-j, mit j = 1, ..., m, und von Modulationsspulen 36-i, mit i = 1, ..., n, mit natürlichen Zahlen n und m (m = Anzahl der Streifenleitungs-Resonatoren, n = Anzahl der Modulationsspulen) vorgesehen sein kann. Während in der Gestaltung der Fig. 2 der Fall n = m = 2 gezeigt ist, gilt im Allgemeinen m ≥ 1 und n ≥ 2, wobei n gleich m, aber auch ungleich m sein kann.

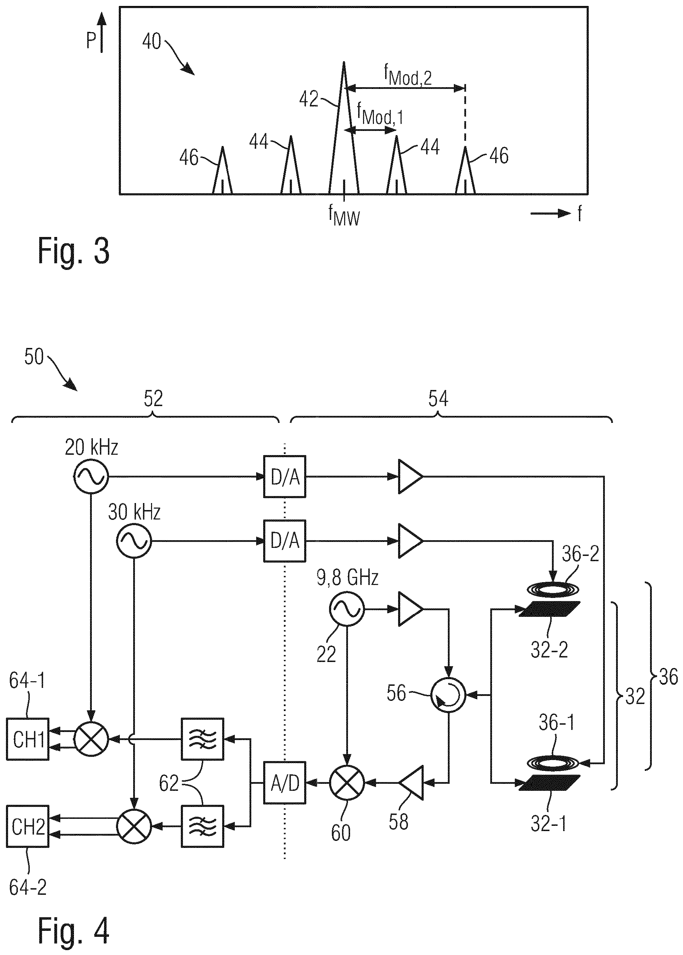

Die Modulationsspulen 36-i des Modulationsspulen-Arrays 36 erzeugen im Ausführungsbeispiel für jeden Resonator der Resonatoreinrichtung 32 ein lokales Modulationsfeld mit einer eigenen Modulations-Frequenz $f_{Mod,i}$. Dadurch entstehen in der spektralen Leistungsverteilung 40 des reflektierten Mikrowellen-Signals für jeden Resonator 32-j spezifische Modulationspeaks 44 bzw. 46, wie in Fig. 3 illustriert. Diese Modulationspeaks 44, 46 können digital, also bauraumsparend, im Lock-In-Verfahren über die Frequenz voneinander getrennt werden.

Konkret erhalten bei dem Ausführungsbeispiel der Figuren 2 und 3 die Resonatoren 32-1, 32-2 durch die gemeinsame Beschaltung 38 von der Signalquelle 22 ein Anregesignal derselben Frequenz $f_{MW}$. In der Modulationseinrichtung 36 erzeugt die erste Modulationsspule 36-1 ein Modulationsfeld mit der Frequenz $f_{Mod,1}$, und die Modulationsspule 36-2 ein Modulationsfeld mit einer unterschiedlichen Frequenz $f_{Mod,2} \neq f_{Mod,1}$.

Die beiden Modulationsfrequenzen sind dabei so gewählt, dass sie nicht einem einfachen ganzzahligen Verhältnis stehen und ihre Differenz ist so groß gewählt, dass sich die Modulationsfrequenzen $f_{Mod,1}$, $f_{Mod,2}$ um mehr als ihre Linienbreite und um mehr als die Linienbreite des Hochfrequenz-Signals der Resonatoren 32-1, 32-2 unterscheiden.

Insbesondere unterscheiden sich die Modulationsfrequenzen sogar um mehr als das Doppelte der größten der genannten Linienbreiten.

Mit Bezug auf das in Fig. 3 gezeigte Leistungsspektrum 40 des reflektierten Hochfrequenz-Signals ist die Trägerfrequenz $f_{MW}$ (Bezugszeichen 42) von ersten Modulationspeaks 44 flankiert, die um $\pm f_{Mod,1}$ gegen die Trägerfrequenz 42 versetzt sind, und ist von zweien Modulationspeaks 46 flankiert, die um $\pm f_{Mod,2}$ gegen die Trägerfrequenz 42 versetzt sind. Die Modulationspeaks 44, 46 können im Lock-In-Verfahren über die Frequenz einfach voneinander getrennt werden.

Im Rahmen der Erfindung sind auch Resonatoreinrichtungen 32 und Modulationseinrichtungen 36 mit einer größeren Anzahl an Streifenleitungs-Resonatoren bzw. Modulationsspulen möglich, solange sichergestellt ist, dass die verschiedenen Frequenzkomponenten im Leistungsspektrum noch sauber getrennt werden können.

Das Ausführungsbeispiel der Fig. 2 zeigt eine vorteilhafte Ausgestaltung, bei der die Anzahl m der Resonatoren 32-j gleich der Anzahl n der Modulationsspulen 36-i ist und bei der die Resonatoren 32-j und Modulationsspulen 36-i einander paarweise zugeordnet sind. Die Modulationsspulen 36-i sind bei diesem Ausführungsbeispiel in Form eines eindimensionalen Arrays 36 angeordnet, das sich quer zur Transportrichtung 14 der Banknote 10 erstreckt. In Verbindung mit der Bewegung des Banknotenprüflings wird dadurch ein zweidimensionaler Scan des transportierten Banknotenprüflings 10 ermöglicht.

Neben der in Fig. 2 gezeigten Parallelschaltung sind auch eine Reihenschaltung oder eine Kombination von Reihen- und Parallelschaltung für die Resonatoren 32- i möglich. In einer anderen Ausführung kann auch ein einzelner Resonator mit ausgedehnter Feldverteilung, insbesondere mit mehreren lokalisierten Feldmaxima durch den Betrieb in einer höheren räumlichen Mode, den Bereich mehrerer Modulationsspulen überdecken.

Für eine korrekte Funktionalität des Modulationsspulen-Arrays ist es vorteilhaft, wenn die Modulationsspulen möglichst wenig "quer-modulieren", also die Modulationskanäle der benachbarten Modulationsspulen kontaminieren. Eine solche Kontamination kann auftreten, wenn etwa die Modulationsspule 36-1 der Fig. 2 ein Modulationsfeld $B_{Mod,1}$ erzeugt, das im sensitiven Bereich des Resonators 32-2 noch eine substantielle Amplitude aufweist, beziehungsweise, wenn umgekehrt die Modulationsspule 36-2 ein Modulationsfeld $B_{Mod,2}$ erzeugt, das im sensitiven Bereich des Resonators 32-1 noch eine substantielle Amplitude aufweist.

Liegt eine gleiche Anzahl k = n = m von Resonatoren und Modulationsspulen vor, so kann ein Kontaminationsfaktor $\chi_{ij}$ definiert werden durch

$$\chi_{ij} = \frac{\int B_{Mod,j} dV_i}{\int B_{Mod,i} dV_i}$$

mit j = 1, ..., k, und i = 1, ..., k.

Der Kontaminationsfaktor $\chi_{ij}$ gibt die Größe der parasitären Signalanteile anderer Modulationsfrequenzen an, welche durch eine Quer-Modulation im Resonator 32-i entstehen. Das für die Integration zu verwendende Volumen $V_i$ beschreibt dabei den sensitiven Bereich des Resonators 32-i.

Für i = j sind die Größen $\chi_{ii}$ formal ebenfalls definiert und nach Konstruktion gleich 1, sie beschreiben allerdings keine Kontamination, sondern das erwünschte, durch die Modulationsspule 36-i im zugehörigen Resonator 32-i erzeugte Signal, und werden bei der Summenbildung daher außer Acht gelassen.

Für die Funktionalität des Modulationsspulen-Arrays 36 ist es nun vorteilhaft, dass für jeden Modulationskanal 36-i die Summe über alle Kontaminationsfaktoren, also

$$\sum_{j}^{j \neq i} \chi_{ij}$$

kleiner als 2% ist. Besonders vorteilhaft ist die Summe für jeden Modulationskanal sogar kleiner als 0,5 %.

Eine analoge Definition der Kontaminationsfaktoren und der Summe der Kontaminationsfaktoren kann genutzt werden, wenn die Anzahl m der Resonatoren ungleich der Anzahl n der Modulationsspulen ist.

Um die überlegene Leistung erfindungsgemäßer Sensorelemente zu demonstrieren, wurde das Verhalten eines Sensorelements nach Fig. 2 mit einem Array aus zwei Modulationsspulen 36-1, 36-2 und zwei quadratischen λ/2-Streifenleitungs-Resonatoren 32-1, 32-2 simuliert.

Die der Simulation zugrunde liegende Schaltung 50 ist in Fig. 4 schematisch dargestellt. Sie enthält einen digitalen Teil 52 und einen analogen Teil 54.

Die beiden λ/2-Streifenleitungs-Resonatoren 32-1, 32-2 sind auf einer Leiterplatte der Stärke 1,5 mm aufgebaut, deren Dielektrizitätskonstante 3,66 beträgt. Die Resonatoren 32-1, 32-2 haben einen Abstand von 15 mm zueinander, die Kantenlänge der Resonatoren beträgt jeweils 7,1 mm, entsprechend einer Resonanzfrequenz von 9,8 GHz.

Die Impedanz eines jeden Resonators 32-1, 32-2 wird mit Hilfe eines λ/4-Impedanztransformators auf 100 Ω transformiert. Über die anschließende Parallelschaltung der beiden Grundelemente erhält man eine Gesamtimpedanz von 50 Ω. Das aus den beiden Resonatoren gebildete Resonator-Array 32 wird über einen Zirkulator 56 vom verstärkten Ausgangssignal einer Signalquelle 22 gespeist. Die Signalquelle 22 wird bei 9,8 GHz im Dauerstrich (CW)-Modus betrieben.

Zu jedem Resonator 32-1 bzw. 32-2 ist in einem Abstand von 2 mm gegenüberliegend eine planare Modulationsspule 36-1 bzw. 36-2 platziert. Die Modulationsspulen 36-1, 36-2 sind spiralförmig aufgebaut, haben 15 Windungen und einen Durchmesser von 5 mm. Die Modulationsspule 36-1 des ersten Resonators 32-1 wird mit einer Frequenz $f_{Mod,1}$ = 20 kHz betrieben, die Modulationsspule 36-2 des zweiten Resonators 32-2 mit einer Frequenz $f_{Mod,2}$ = 30 kHz. Die jeweiligen Modulationssignale werden in einem FPGA digital erzeugt, anschließend einer D/A-Konvertierung unterzogen und so verstärkt, dass durch beide Modulationsspulen 36-1, 36-2 der gleiche Strom fließt.

Das Resonator-Array 32 und das Modulationsspulen-Array 36 wurden in den Luftspalt eines magnetischen Kreises gebracht und dort mit einer mit einem Spinresonanz-Merkmal versehenen Papierprobe beladen. Die Larmor-Frequenz des Spinresonanz-Merkmals entspricht bei dem vorliegenden Polarisationsfeld gerade der 9,8 GHz Anregefrequenz.

Im nächsten Schritt wurde das vom Resonator-Array 32 reflektierte Signal mit einem rauscharmen Empfangsverstärker 58 verstärkt und mit dem 9,8 GHz Anregesignal abwärtsgemischt (Bezugszeichen 60). Der Phasenschieber sowie die Filterbänke sind der Übersichtlichkeit halber in Fig. 4 nicht dargestellt. Nach dem Abwärtsmischen wird das Signal digitalisiert und dem FPGA zugeführt.

Im FPGA wird das Signal in zwei Kanäle aufgeteilt. Beide Kanäle werden Bandpass-gefiltert (Bezugszeichen 62), wobei der erste Kanal eine Mittenfrequenz von 20 kHz und der zweite Kanal eine Mittenfrequenz von 30 kHz aufweist. Beide Filter haben eine Bandbreite von 5 kHz. Der erste Kanal wird anschließend mit dem 20 kHz-Modulationssignal demoduliert, der zweite Kanal mit dem 30 kHz-Modulationssignal, und die demodulierten Ausgangssignale werden einer Auswerteeinheit 64-1 für Kanal 1 und einer Auswerteeinheit 64-2 für Kanal 2 zugeführt. Bei der Demodulation handelt es sich um eine Quadratur-Amplitudendemodulation. Die dabei verwendeten Phasenschieber sind wiederum in der Figur nicht dargestellt. Die dazugehörigen Filterbänke, die in der Figur ebenfalls nicht gezeigt sind, haben eine Bandbreite von 2,5 kHz.

Schließlich wurde das Polarisationsfeld des magnetischen Kreises mit einem Feld-Sweep durchfahren und die Ausgangssignale der beiden Kanäle von den Auswerteeinheiten 64-1, 64-2 aufgezeichnet. Beide Kanäle zeigen das Spektrum des für die Dotierung verwendeten Spinresonanz-Merkmals und entsprechen verschiedenen Messpunkten auf der Banknote.

Bezugszeichenliste

| 10 | Banknotenprüfling |
|---|---|
| 12 | Spinresonanz-Merkmal |
| 14 | Transportpfad |
| 20 | Prüfvorrichtung |
| 22 | Signalquelle |
| 24 | Duplexer |
| 26 | Detektor-Diode |
| 28 | Auswerteeinheit |
| 30 | Sensorelement |
| 32 | Resonatoreinrichtung |
| 32-1, 32-2, 32-j | Resonatoren |
| 34 | Polarisationseinrichtung |
| 36 | Modulationseinrichtung |
| 36-1, 36-2, 36-i | Modulationsspulen |
| 40 | spektralen Leistungsverteilung |
| 42 | Trägerfrequenz |
| 44, 46 | Modulationspeaks |
| 50 | Schaltung |
| 52 | digitaler Schaltungsteil |
| 54 | analoger Schaltungsteil |
| 56 | Zirkulator |
| 58 | Empfangsverstärker |
| 60 | Abwärtsmischung |
| 62 | Bandpass-Filterung |
| 64-1, 64-2 | Auswerteeinheiten |

**Patentansprüche**

1. Sensorelement (30) für die Prüfung eines flächigen Datenträgers (10), insbesondere einer Banknote, mit einem Spinresonanz-Merkmal (12), mit

   - einem Magnetkern mit einem Luftspalt, in den der flächige Datenträger (10) zur Prüfung einbringbar ist,
   - einer Polarisationseinrichtung (34) zu Erzeugung eines statischen magnetischen Flusses in dem Luftspalt,
   - einer Resonatoreinrichtung (32) zur Anregung des Spinresonanz-Merkmals des zu prüfenden Datenträgers in dem Luftspalt, mit zumindest einem von einer Signalquelle (22) gespeisten Streifenleitungs-Resonator (32-1, 32-2), und
   - einer Modulationseinrichtung (36) zur Erzeugung eines zeitlich variierenden magnetischen Modulationsfelds in dem Luftspalt parallel zu dem statischen Magnetfeld,

   wobei die Modulationseinrichtung (36) eine Mehrzahl von Modulationsspulen (36-1, 36-2) umfasst, die für die Erzeugung verschiedener Modulationsfrequenzen ausgebildet und eingerichtet sind, so dass das durch die Modulationseinrichtung (36) zusammen mit der Polarisationseinrichtung (34) erzeugte modulierte Magnetfeld an verschiedenen Orten innerhalb des Luftspalts verschiedene Modulationsfrequenzen aufweist.

2. Sensorelement (30) nach Anspruch 1, **dadurch gekennzeichnet, dass** die Modulationsspulen (36-1, 36-2) der Modulationseinrichtung (36) versetzt nebeneinander angeordnet sind.

3. Sensorelement (30) nach Anspruch 1 oder 2, **dadurch gekennzeichnet, dass** zumindest eine, vorzugsweise alle, Modulationsspulen (36-1, 36-2) der Modulationseinrichtung (36) durch Planarspulen gebildet sind, die in einer Ebene eine oder mehrere Windungen um eine Axialrichtung des Luftspalts aufweisen.

4. Sensorelement (30) nach wenigstens einem der Ansprüche 1 bis 3, **dadurch gekennzeichnet, dass** die Modulationsspulen (36-1, 36-2) in derselben Ebene auf einem gemeinsamen Spulenträger, insbesondere einer gemeinsamen Leiterplatte, angeordnet sind.

5. Sensorelement (30) nach wenigstens einem der Ansprüche 1 bis 4, **dadurch gekennzeichnet, dass** die Modulationsspulen (36-1, 36-2) zur Erzeugung von Modulationsfrequenzen ausgebildet und eingerichtet sind, die nicht in einem einfachen ganzzahligen Verhältnis zueinander stehen, insbesondere nicht in einem Verhältnis 1:n, mit einer natürlichen Zahl n kleiner als 6; und/oder

   **dadurch gekennzeichnet, dass** die Modulationsspulen (36-1, 36-2) zur Erzeugung von Modulationsfrequenzen ausgebildet und eingerichtet sind, die sich um mehr als ihre Linienbreite und um mehr als die Linienbreite des Hochfrequenz-Signals der Resonatoren unterscheiden.

6. Sensorelement (30) nach wenigstens einem der Ansprüche 1 bis 5, **dadurch gekennzeichnet, dass** die Modulationsspulen (36-1, 36-2) der Modulationseinrichtung (36) in Form eines eindimensionalen Arrays angeordnet sind; und/oder

   **dadurch gekennzeichnet, dass** sich die Anordnung der Modulationsspulen (36-1, 36-2) über die gesamte Breite des zu prüfenden Datenträgers, insbesondere einer Banknote, erstreckt.

7. Sensorelement (30) nach wenigstens einem der Ansprüche 1 bis 6, **dadurch gekennzeichnet, dass** die Resonatoreinrichtung (32) eine Mehrzahl von Streifenleitungs-Resonatoren (32-1, 32-2) aufweist, insbesondere, dass die Anzahl der Streifenleitungs-Resonatoren (32-1, 32-2) in der Resonatoreinrichtung (32) gleich der Anzahl der Modulationsspulen (36-1, 36-2) in der Modulationseinrichtung (36) ist, oder dass die Anzahl der Streifenleitungs-Resonatoren in der Resonatoreinrichtung ein ganzzahliges Vielfaches der Anzahl der Modulationsspulen in der Modulationseinrichtung ist.

8. Sensorelement (30) nach wenigstens einem der Ansprüche 1 bis 7, **dadurch gekennzeichnet, dass** die Streifenleitungs-Resonatoren (32-1, 32-2) der Resonatoreinrichtung (32) die gleiche Resonanzfrequenz haben, vorzugsweise, dass die Streifenleitungs-Resonatoren (32-1, 32-2) der Resonatoreinrichtung (32) auf Betrieb in der gleichen räumlichen Mode ausgelegt und eingerichtet sind, und weiter vorzugsweise, dass die Streifenleitungs-Resonatoren (32-1, 32-2) der Resonatoreinrichtung (32) die gleiche geometrische Form aufweisen.

9. Sensorelement (30) nach wenigstens einem der Ansprüche 1 bis 8, **dadurch gekennzeichnet, dass** die Streifenleitungs-Resonatoren (32-1, 32-2) der Resonatoreinrichtung (32) in derselben Ebene, vorteilhaft auf einem gemeinsamen Resonatorträger, insbesondere einer gemeinsamen Leiterplatte, angeordnet sind, wobei die genannte Ebene insbesondere senkrecht auf der Richtung des statischen magnetischen Flusses steht.

10. Sensorelement (30) nach wenigstens einem der Ansprüche 1 bis 9, **dadurch gekennzeichnet, dass** die Polarisationseinrichtung (34) am Ort der Streifenleitungs-Resonatoren (32-1, 32-2) jeweils im Wesentlichen den gleichen statischen magnetischen Fluss erzeugt; oder

    **dadurch gekennzeichnet, dass** die Polarisationseinrichtung (34) im Luftspalt einen räumlich inhomogenen statischen magnetischen Fluss erzeugt.

11. Sensorelement (30) nach wenigstens einem der Ansprüche 1 bis 10, **dadurch gekennzeichnet, dass** das modulierte Magnetfeld im Messbereich jedes Streifenleitungs-Resonators im Wesentlichen nur eine einzige Modulationsfrequenz aufweist.

12. Sensorelement (30) nach wenigstens einem der Ansprüche 1 bis 11, **dadurch gekennzeichnet, dass** der Luftspalt eine Höhe von weniger als 10 mm, insbesondere von weniger als 5 mm, aufweist.

13. Prüfvorrichtung (20) für die Prüfung eines flächigen Datenträgers, insbesondere einer Banknote, mit einem Spinresonanz-Merkmal, mit

    - einem Sensorelement (30) nach einem der Ansprüche 1 bis 12,
    - genau einer Signalquelle (22), von der alle Streifenleitungs-Resonatoren der Resonatoreinrichtung (32) gespeist werden,
    - einem Detektor zur Messung der von der Resonatoreinrichtung (32) reflektierten Hochfrequenz-Leistung, und
    - eine Auswerteeinheit (28) zur Auswertung und gegebenenfalls Anzeige des Messergebnisses.

14. Prüfvorrichtung (20) nach Anspruch 13, mit einer Transporteinrichtung, die die zu prüfenden flächigen Datenträger (10) entlang eines Transportpfades (14) in den Luftspalt des Magnetkerns einbringt bzw. durch den Luftspalt des Magnetkerns hindurchführt, wobei die Modulationsspulen der Modulationseinrichtung (36) in Form eines eindimensionalen Arrays angeordnet sind, das sich quer zur Richtung des Transportpfades (14) erstreckt.

15. Verfahren zur Prüfung eines flächigen Datenträgers (10), insbesondere einer Banknote, mit einem Spinresonanz-Merkmal (12) mittels eines Sensorelements (30) nach einem der Ansprüche 1 bis 12 oder einer Prüfvorrichtung (20) nach Anspruch 13 oder 14, wobei bei dem Verfahren

    - ein zu prüfender flächiger Datenträger (10) in den Luftspalt des Magnetkerns des genannten Sensorelements (30) eingebracht wird,
    - mit der Polarisationseinrichtung (34) ein statischer magnetischer Fluss und mit der Modulationseinrichtung (36) ein zeitlich variierendes magnetisches Modulationsfeld in dem Luftspalt erzeugt wird, so dass das durch die Modulationseinrichtung (36) zusammen mit der Polarisationseinrichtung (34) erzeugte modulierte Magnetfeld an verschiedenen Orten innerhalb des Luftspalts verschiedene Modulationsfrequenzen aufweist, und
    - mit der Resonatoreinrichtung (32) das Spinresonanz-Merkmal (12) des zu prüfenden Datenträgers (10) angeregt wird.

**Claims**

1. Sensor element (30) for testing a flat data carrier (10), in particular a banknote, with a spin resonance feature (12), with

    - a magnetic core with an air gap into which the flat data carrier (10) can be inserted for testing,
    - a polarization device (34) for generating a static magnetic flux in the air gap,
    - a resonator device (32) for exciting the spin resonance characteristic of the data carrier to be tested in the air gap, with at least one strip line resonator (32-1, 32-2) fed by a signal source (22), and
    - a modulation device (36) for generating a temporally varying magnetic modulation field in the air gap parallel to the static magnetic field,

wherein the modulation device (36) comprises a plurality of modulation coils (36-1, 36-2) that are designed and set up to generate different modulation frequencies, so that the modulated magnetic field generated by the modulation device (36) together with the polarization device (34) has different modulation frequencies at different locations within the air gap.

2. Sensor element (30) according to claim 1, **characterized in that** the modulation coils (36-1, 36-2) of the modulation device (36) are arranged offset next to each other.

3. Sensor element (30) according to claim 1 or 2, **characterized in that** at least one, preferably all, modulation coils (36-1, 36-2) of the modulation device (36) are formed by planar coils ( ) which have one or more turns in a plane around an axial direction of the air gap.

4. Sensor element (30) according to at least one of claims 1 to 3, **characterized in that** the modulation coils (36-1, 36-2) are arranged in the same plane on a common coil carrier ( ), in particular a common printed circuit board.

5. Sensor element (30) according to at least one of claims 1 to 4, **characterized in that** the modulation coils (36-1, 36-2) are designed and configured to generate modulation frequencies that are not in a simple integer ratio to each other, in particular not in a ratio of 1:n, with a natural number n less than 6; and/or
**characterized in that** the modulation coils (36-1, 36-2) are designed and configured to generate modulation frequencies that differ by more than their line width and by more than the line width of the high-frequency signal of the resonators.

6. Sensor element (30) according to at least one of claims 1 to 5, **characterized in that** the modulation coils (36-1, 36-2) of the modulation device (36) are arranged in the form of a one-dimensional array; and/or
**characterized in that** the arrangement of the modulation coils (36-1, 36-2) extends over the entire width of the data carrier to be tested, in particular a banknote.

7. Sensor element (30) according to at least one of claims 1 to 6, **characterized in that** the resonator device (32) has a plurality of strip line resonators (32-1, 32-2), in particular **in that** the number of strip line resonators (32-1, 32-2) in the resonator device (32) is equal to the number of modulation coils (36-1, 36-2) in the modulation device (36), or that the number of strip line resonators in the resonator device is an integer multiple of the number of modulation coils in the modulation device.

8. Sensor element (30) according to at least one of claims 1 to 7, **characterized in that** the stripline resonators (32-1, 32-2) of the resonator device (32) have the same resonant frequency, preferably **in that** the stripline resonators (32-1, 32-2) of the resonator device (32) are designed and configured for operation in the same spatial mode, and further preferably that the stripline resonators (32-1, 32-2) of the resonator device (32) have the same geometric shape.

9. Sensor element (30) according to at least one of claims 1 to 8, **characterized in that** the strip line resonators (32-1, 32-2) of the resonator device (32) are arranged in the same plane, advantageously on a common resonator carrier, in particular a common printed circuit board, wherein said plane is in particular perpendicular to the direction of the static magnetic flux.

10. Sensor element (30) according to at least one of claims 1 to 9, **characterized in that** the polarization device (34) generates essentially the same static magnetic flux at the location of each of the strip line resonators (32-1, 32-2); or
**characterized in that** the polarization device (34) generates a spatially inhomogeneous static magnetic flux in the air gap.

11. Sensor element (30) according to at least one of claims 1 to 10, **characterized in that** the modulated magnetic field in the measuring range of each strip line resonator has essentially only a single modulation frequency.

12. Sensor element (30) according to at least one of claims 1 to 11, **characterized in that** the air gap has a height of less than 10 mm, in particular less than 5 mm.

13. Test device (20) for testing a flat data carrier, in particular a banknote, with a spin resonance feature, with

   - a sensor element (30) according to one of claims 1 to 12,
   - exactly one signal source (22) from which all strip line resonators of the resonator device (32) are fed,
   - a detector for measuring the high-frequency power reflected by the resonator device (32), and
   - an evaluation unit (28) for evaluating and, if necessary, displaying the measurement result.

14. Test device (20) according to claim 13, with a transport device that transports the flat data carriers (10) to be tested along a transport path (14) into the air gap of the magnetic core or guides them through the air gap of the magnetic core, wherein the modulation coils of the modulation device (36) are arranged in the form of a one-dimensional array extending transversely to the direction of the transport path (14).

15. Method for testing a flat data carrier (10), in particular a banknote, with a spin resonance feature (12) ( ) using a sensor element (30) according to one of claims 1 to 12 or a testing device (20) according to claim 13 or 14, wherein in the method

     - a flat data carrier (10) to be tested is introduced into the air gap of the magnetic core of the said sensor element (30),
     - a static magnetic flux is generated in the air gap using the polarization device (34) and a temporally varying magnetic modulation field is generated in the air gap using the modulation device (36), so that the modulated magnetic field generated by the modulation device (36) together with the polarization device (34) has different modulation frequencies at different locations within the air gap, and
     - the resonator device (32) excites the spin resonance feature (12) of the data carrier (10) to be tested.

**Revendications**

1. Élément capteur (30) pour contrôler un support de données plat (10), en particulier un billet de banque, avec une caractéristique de résonance de spin (12), avec

     - un noyau magnétique avec un entrefer dans lequel le support de données plat (10) peut être introduit pour être contrôlé,
     - un dispositif de polarisation (34) pour générer un flux magnétique statique dans l'entrefer,
     - un dispositif résonateur (32) pour exciter la caractéristique de résonance de spin du support de données à contrôler dans l'entrefer, avec au moins un résonateur à ligne triplaque (32-1, 32-2) alimenté par une source de signal (22), et
     - un dispositif de modulation (36) pour générer un champ de modulation magnétique variant dans le temps dans l'entrefer parallèlement au champ magnétique statique,

le dispositif de modulation (36) comprenant une pluralité de bobines de modulation (36-1, 36-2) qui sont conçues et agencées pour générer différentes fréquences de modulation, de sorte que le champ magnétique modulé généré par le dispositif de modulation (36) conjointement avec le dispositif de polarisation (34) présente différentes fréquences de modulation à différents endroits à l'intérieur de l'entrefer.

2. Élément capteur (30) selon la revendication 1, **caractérisé en ce que** les bobines de modulation (36-1, 36-2) du dispositif de modulation (36) sont disposées de manière décalée les unes à côté des autres.

3. Élément capteur (30) selon la revendication 1 ou 2, **caractérisé en ce qu'**au moins une, de préférence toutes les bobines de modulation (36-1, 36-2) du dispositif de modulation (36) sont formées par des bobines planaires à , qui présentent dans un plan une ou plusieurs spires autour d'une direction axiale de l'entrefer.

4. Élément capteur (30) selon au moins l'une des revendications 1 à 3, **caractérisé en ce que** les bobines de modulation (36-1, 36-2) sont disposées dans le même plan sur un support de bobines commun ( ), en particulier une carte de circuit imprimé commune.

5. Élément capteur (30) selon au moins l'une des revendications 1 à 4, **caractérisé en ce que** les bobines de modulation (36-1, 36-2) sont conçues et agencées pour générer des fréquences de modulation qui ne sont pas dans un rapport entier simple les unes par rapport aux autres, en particulier pas dans un rapport 1:n, avec un nombre naturel n inférieur à 6 ; et/ou
**caractérisé en ce que** les bobines de modulation (36-1, 36-2) sont conçues et agencées pour générer des fréquences de modulation qui diffèrent de plus de leur largeur de bande et de plus de la largeur de bande du signal haute fréquence des résonateurs.

6. Élément capteur (30) selon au moins l'une des revendications 1 à 5, **caractérisé en ce que** les bobines de modulation (36-1, 36-2) du dispositif de modulation (36) sont disposées sous la forme d'un réseau unidimensionnel ; et/ou
**caractérisé en ce que** la disposition des bobines de modulation (36-1, 36-2) s'étend sur toute la largeur du support de données à contrôler, en particulier d'un billet de banque.

7. Élément capteur (30) selon au moins l'une des revendications 1 à 6, **caractérisé en ce que** le dispositif résonateur (32) comporte une pluralité de résonateurs à ligne triplaque (32-1, 32-2), en particulier **en ce que** le nombre de résonateurs à ligne triplaque (32-1, 32-2) dans le dispositif résonateur (32) est égal au nombre de bobines de modulation (36-1, 36-2) dans le dispositif de modulation (36), ou que le nombre de résonateurs à ligne triplaque dans le dispositif résonateur est un multiple entier du nombre de bobines de modulation dans le dispositif de modulation.

8. Élément capteur (30) selon au moins l'une des revendications 1 à 7, **caractérisé en ce que** les résonateurs à ligne triplaque (32-1, 32-2) du dispositif résonateur (32) de l' ont la même fréquence de résonance, de préférence **en ce que** les résonateurs à ligne triplaque (32-1, 32-2) du dispositif résonateur (32) sont conçus et agencés pour fonctionner dans le même mode spatial, et de préférence encore que les résonateurs à ligne triplaque (32-1, 32-2) du dispositif résonateur (32) ont la même forme géométrique.

9. Élément capteur (30) selon au moins l'une des revendications 1 à 8, **caractérisé en ce que** les résonateurs à ligne triplaque (32-1, 32-2) du dispositif résonateur (32) sont disposés dans le même plan, de préférence sur un support de résonateur commun, en particulier une carte de circuit imprimé commune, ledit plan étant en particulier perpendiculaire à la direction du flux magnétique statique.

10. Élément capteur (30) selon au moins l'une des revendications 1 à 9, **caractérisé en ce que** le dispositif de polarisation (34) génère sensiblement le même flux magnétique statique à l'emplacement des résonateurs à ligne triplaque (32-1, 32-2) ; ou **caractérisé en ce que** le dispositif de polarisation (34) génère un flux magnétique statique spatialement non homogène dans l'entrefer.

11. Élément capteur (30) selon au moins l'une des revendications 1 à 10, **caractérisé en ce que** le champ magnétique modulé dans la plage de mesure de chaque résonateur à ligne à ruban ne présente pour l'essentiel qu'une seule fréquence de modulation.

12. Élément capteur (30) selon au moins l'une des revendications 1 à 11, **caractérisé en ce que** l'entrefer présente une hauteur inférieure à 10 mm, en particulier inférieure à 5 mm.

13. Dispositif de contrôle (20) pour contrôler un support de données plat, en particulier un billet de banque, avec une caractéristique de résonance de spin, avec

- un élément capteur (30) selon l'une des revendications 1 à 12,
- exactement une source de signal (22) qui alimente tous les résonateurs à ligne à ruban du dispositif résonateur (32),
- un détecteur pour mesurer la puissance haute fréquence réfléchie par le dispositif résonateur (32), et

- une unité d'évaluation (28) pour évaluer et, le cas échéant, afficher le résultat de la mesure.

14. Dispositif de contrôle (20) selon la revendication 13, comprenant un dispositif de transport qui introduit les supports de données plats (10) à contrôler dans l'entrefer du noyau magnétique le long d'un chemin de transport (14) dans l'entrefer du noyau magnétique ou à travers l'entrefer du noyau magnétique, les bobines de modulation du dispositif de modulation (36) étant disposées sous la forme d'un réseau unidimensionnel qui s'étend transversalement à la direction du chemin de transport (14).

15. Procédé pour contrôler un support de données plat (10), en particulier un billet de banque, présentant une caractéristique de résonance de spin (12) d', à l'aide d'un élément capteur (30) selon l'une des revendications 1 à 12 ou d'un dispositif de contrôle (20) selon la revendication 13 ou 14, dans lequel

- un support de données plat (10) à contrôler est introduit dans l'entrefer du noyau magnétique dudit élément capteur (30),
- un flux magnétique statique est généré dans l'entrefer à l'aide du dispositif de polarisation (34) et un champ de modulation magnétique variant dans le temps est généré dans l'entrefer à l'aide du dispositif de modulation (36), de sorte que le champ magnétique modulé généré par le dispositif de modulation (36) conjointement avec le dispositif de polarisation (34) présente différentes fréquences de modulation à différents endroits à l'intérieur de l'entrefer, et
- le dispositif résonateur (32) excite la caractéristique de résonance de spin (12) de l' e du support de données (10) à tester.

Fig. 1

Fig. 2

EP 4 519 708 B1

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3638104 A
- US 5149946 A